# EUROPEAN PATENT APPLICATION

(11) **EP 3 702 425 A1**
(43) Date of publication of application: **02.09.2020**
(21) Application number: 20159825.7
(22) Date of filing: 27.02.2020
(51) Int. Cl.: C09G 1/02

(54) **CHEMICAL MECHANICAL POLISHING FOR COPPER AND THROUGH SILICON VIA APPLICATIONS**

(30) Priority: 28.02.2019 US 201962811874 P; 24.01.2020 US 202016752116
(71) Applicant: Versum Materials US, LLC, Tempe, AZ 85284 (US)
(72) Inventor: SHI, Xiaobo, Tempe, Arizona 85284 (US); SCHLUETER, James Allen, Tempe, Arizona 85284 (US); O'NEILL, Mark Leonard, Tempe, Arizona 85284 (US)
(74) Representative: Beck Greener LLP

(57) **Abstract**

Provided are Chemical Mechanical Planarization (CMP) compositions that offer very high and tunable Cu removal rates for the broad bulk or advanced node copper or Through Silicon Via (TSV). The CMP compositions provide high selectivity of Cu film vs. other barrier layers, such as Ta, TaN, Ti, and TiN, and dielectric films, such as TEOS, low-k, and ultra low-k films. The CMP polishing compositions comprise solvent, abrasive, oxidizer, at least two chelators selected from the group consisting of amino acids, amino acid derivatives, organic amine, and combinations therefore; wherein at least one chelator is an amino acid or an amino acid derivative. Organic quaternary ammonium salt, corrosion inhibitor, pH adjustor and biocide can be used in the compositions.

## Description

### CROSS REFERENCE TO RELATED PATENT APPLICATIONS

The application claims the benefit of U.S. Application No. 62/811,874 filed on February 28th, 2019. The disclosure of Application No. 62/798,638 is hereby incorporated by reference.

### BACKGROUND OF THE INVENTION

This invention relates generally to the chemical-mechanical planarization or chemical-mechanical polishing (CMP) of semiconductor wafers. More specifically, present invention relates to high and tunable Cu film removal rates for the broad or advanced node copper or Through Silicon Via (TSV) CMP applications. CMP polishing formulations, CMP polishing compositions or CMP polishing slurries are interchangeable in present invention.

Copper is the current material of choice for interconnect metal used in the fabrication of integrated electronic devices due to its low resistivity, high reliability, and scalability. Copper chemical mechanical planarization processes are necessary to remove copper overburden from inlaid trench structures while achieving global planarization with low metal loss.

With advancing technology nodes the need to reduce metal loss becomes increasingly important. Any new polishing formulations must also maintain high removal rates, high selectivity to the barrier material and low defectivity.

Copper CMP have been done in the art, for example, US9,3065,806; US20160314989; US20130092651; US 20130078811; US 8,679,980; US 8,791,019; US 8,435,421; US 7,955,520; US 20130280910; US 20100221918; US 8,236,695; TW I385226; US 20120094490; US 7,955,520; US US20040175942; US6773476; US8236695; 20090053896; US8,586,481; US20100221918; US20170271172; US2017035139; US20110070736; US20080254628; and US20100015807.

However, the disclosed formulations were unable to meet the performance requirements of high Cu removal rates which become more and more challenging for advanced technology nodes.

This invention discloses bulk copper CMP polishing formulations developed to meet challenging requirements of high Cu removal rates for the advanced technology node Cu CMP applications.

### Summary of The Invention

Described herein are CMP polishing compositions, methods and systems for the copper and Through Silicon Via (TSV) CMP applications.
1. In one aspect, the invention herein provides a copper chemical mechanical polishing (CMP) composition comprising:
   a) abrasive;
   b) at least two chelators;
   c) oxidizing agent; and
   d) water;
   wherein
   the at least two chelators comprise (1) at least one organic amine; and (2) one selected from the group consisting of at least one amino acid, at least one amino acid derivative, and combinations thereof;
      and
   the pH of the composition is from 5.5 to 7.5.

The present invention also describes a chemical mechanical polishing (CMP) composition for a copper bulk and Through Silicon Via (TSV) comprising:
a) abrasive;
b) at least two chelators; and
c) oxidizing agent;
d) water;
optionally
e) corrosion inhibitor;
f) organic quaternary ammonium salt;
g) biocide; and
h) pH adjusting agent;
wherein
the at least two chelators are independently selected from the group consisting of amino acids, amino acid derivatives, organic amine, and combinations therefor; wherein at least one chelator is an amino acid or an amino acid derivative; and
the pH of the composition is from 3.0 to 12.0; preferably from 5.5 to 7.5; and more preferably from 7.0 to 7.35.

In another aspect, the invention provides a method of chemical mechanical polishing a semiconductor substrate having at least one surface comprising copper (Cu) or copper-containing material and at least one second material; comprising steps of:
1) providing the semiconductor substrate;
2) providing a polish pad;
3) providing a Cu chemical mechanical polishing composition of the invention
4) contacting the at least one surface with the polish pad and the Cu chemical mechanical polishing composition; and
5) polishing the at least one surface to remove copper or copper-containing material.

The invention also provides a method of chemical mechanical polishing a semiconductor substrate containing at least one copper or copper-containing surface, comprising steps of:
i. providing the semiconductor substrate;
ii. providing a polish pad;
iii. providing a chemical mechanical polishing composition comprising
   a) abrasive;
   b) oxidizing agent;
   c) at least two chelators; and
   d) water;
   a. optionally
   e) corrosion inhibitor;
   f) organic quaternary ammonium salt;
   g) biocide; and
   h) pH adjusting agent;
      wherein
      the at least two chelators are independently selected from the group consisting of amino acids, amino acid derivatives, organic amine, and combinations therefor; wherein at least one chelator is an amino acid or an amino acid derivative; and
      the pH of the composition is from 3.0 to 12.0; preferably from 5.5 to 7.5; and more preferably from 7.0 to 7.35;
iv. contacting the semiconductor substrate with the polish pad and the chemical mechanical polishing composition; and
v. polishing the semiconductor substrate;
   wherein at least a portion of the at least one copper or copper-containing surface is in contact with both the polishing pad and the chemical mechanical polishing composition.

In yet another aspect, the invention provides a method of a selective chemical mechanical polishing comprising steps of:
a) providing a semiconductor substrate having at least one surface containing a first material and at least one second material;
b) providing a polishing pad;
c) providing a chemical mechanical polishing or Through Silicon Via (TSV) composition comprising
   i. abrasive;
   ii. oxidizing agent;
   iii. at least two chelators; and
   iv. water;
      optionally
   v. corrosion inhibitor;
   vi. organic quaternary ammonium salt;
   vii. biocide; and
   viii. pH adjusting agent;
      wherein
      the at least two chelators are independently selected from the group consisting of amino acids, amino acid derivatives, organic amine, and combinations therefor; wherein at least one chelator is an amino acid or an amino acid derivative;
      the pH of the composition is from 3.0 to 12.0; preferably from 5.5 to 7.5; and more preferably from 7.0 to 7.35;
d) polishing the semiconductor substrate to selectively remove the first material; wherein removal rate of the first material to removal rate of the second material is equal or greater than 500:1; preferably 1000:1; and more preferably 3000:1; and the first material is copper and the second material is selected from the group consisting of barrier layer such as Ta, TaN, Ti, and TiN film, dielectric layer such as TEOS, low-k, and ultra-low-k film.

In yet another aspect, the invention provides a system for chemical mechanical polishing a semiconductor substrate having at least one surface comprising copper (Cu) or copper-containing material and at least one second material; comprising steps of:
1) providing the semiconductor substrate;
2) providing a polish pad;
3) providing a Cu chemical mechanical polishing composition of the invention
wherein at least a portion of the at least one surface comprising copper (Cu) or copper-containing material and at least one second material is in contact with both the polishing pad and the Cu chemical mechanical polishing composition.

The invention also provides a system of chemical mechanical polishing a semiconductor substrate containing at least one copper or copper-containing surface, comprising
1) the semiconductor substrate;
2) a polish pad; and
3) a chemical mechanical polishing composition comprising
   a) abrasive;
   b) oxidizing agent;
   c) at least two chelators; and
   d) water;
      optionally
   e) corrosion inhibitor;
   f) organic quaternary ammonium salt;
   g) biocide; and
   h) pH adjusting agent;
wherein
the at least two chelators are independently selected from the group consisting of amino acids, amino acid derivatives, organic amine, and combinations therefor; wherein at least one chelator is an amino acid or an amino acid derivative; and
the pH of the composition is from 3.0 to 12.0; preferably from 5.5 to 7.5; and more preferably from 7.0 to 7.35;
wherein at least a portion of the at least one copper or copper-containing surface is in contact with both the polishing pad and the chemical mechanical polishing composition.

The abrasive particles used include, but are not limited to, colloidal silica or high purity colloidal silica; colloidal silica particles doped by other metal oxide within lattice of the colloidal silica, such as alumina doped silica particles; colloidal aluminum oxide including alpha-, beta-, and gamma-types of aluminum oxides; colloidal and photoactive titanium dioxide, cerium oxide, colloidal cerium oxide, nano-sized inorganic metal oxide particles, such as alumina, titania, zirconia, ceria etc.; nano-sized diamond particles, nano-sized silicon nitride particles; mono-modal, bi-modal, multi-modal colloidal abrasive particles; organic polymer-based soft abrasives, surface-coated or modified abrasives, or other composite particles, and mixtures thereof.

The corrosion inhibitors include but are not limited to the family of hetero aromatic compounds containing nitrogen atom(s) in their aromatic rings, such as 1,2,4-triazole, 3-amino-1,2,4-triazole, benzotriazole and benzotriazole derivatives, tetrazole and tetrazole derivatives, imidazole and imidazole derivatives, benzimidazole and benzimidazole derivatives, and pyrazole and pyrazole derivatives, and combinations thereof.. Preferred corrosion inhibitors are 5-chloro-2-methyl-4-isothiazolin-3-one, 2-methyl-4-isothiazolin-3-one, and combinations thereof.

The biocide includes but is not limited to Kathon™, Kathon™ CG/ICP II, from Dow Chemical Co. The biocide preferably has the active ingredients of 5-chloro-2-methyl-4-isothiazolin-3-one and 2-methyl-4-isothiazolin-3-one, and combinations thereof.

The oxidizing agent includes, but is not limited to, periodic acid, hydrogen peroxide, potassium iodate, potassium permanganate, ammonium persulfate, ammonium molybdate, ferric nitrate, nitric acid, potassium nitrate, and mixtures thereof. The preferred oxidizing agent is hydrogen peroxide.

The amino acids and amino acid derivatives include, but not limited to, glycine, D-alanine, L-alanine, DL-alanine, beta-alanine, valine, leucine, isoluecine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof.

The organic amines chelators may have general molecular structures (a)- (i), as depicted below.

The organic amine with structure (a) has two primary amine functional groups as terminal groups on both ends of the molecule.

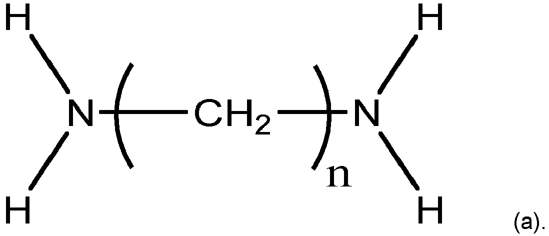

n is numbered from 2 to 12.

For examples, the organic amine is ethylenediamine, 1,3-propanediamine or 1,4-butanediamine as n=2, 3 or 4.

The organic amine with structure (b) also has two primary amine functional groups as terminal groups on both ends of the molecule.

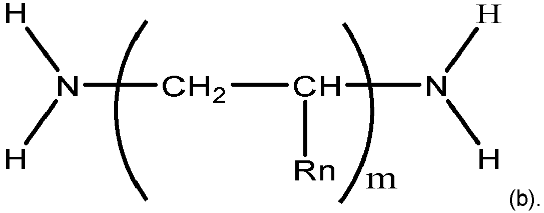

An alkyl group links the two terminal primary amine functional groups. The alkyl group Rn = CₙH₂ₙ₊₁, n is from 1 to 12, preferably 1 to 6, and more preferably 1 to 3.

m can be numbered from 2 to 12.

The linking alkyl group Rn between two terminal primary amine functional groups can also be a branched alkyl group.

The organic amine with structure (c) is shown below.

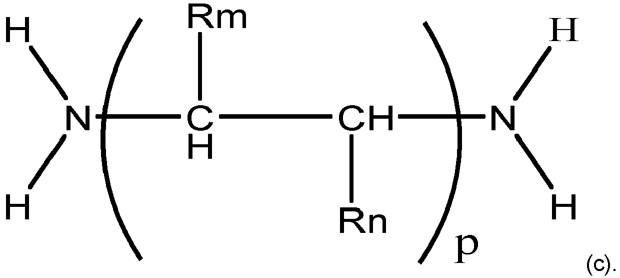

Rn and Rm can be the same or different alkyl groups Rn = CₙH₂ₙ₊₁ and Rm = CₘH₂ₘ₊₁, n is from 1 to 12, preferably 1 to 6, and more preferably 1 to 3; m is from 1 to 12, preferably 1 to 6, and more preferably 1 to 3.

p is from is from 2 to 12, preferably 2 to 6, and more preferably 2 to 3.

The organic amine with structure (d) is shown below.

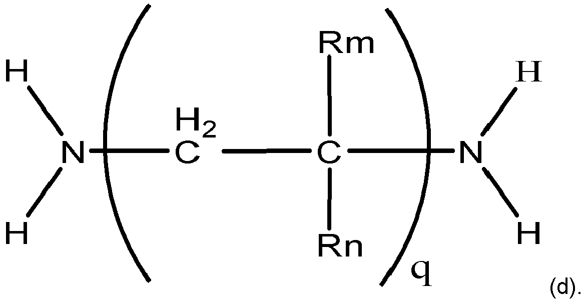

Rn and Rm groups are bonded to the same carbon atom. Rn and Rm can be the same or different alkyl groups Rn = CₙH₂ₙ₊₁ and Rm = CₘH₂ₘ₊₁, n is from 1 to 12, preferably 1 to 6, and more preferably 1 to 3; m is from 1 to 12, preferably 1 to 6, and more preferably 1 to 3.

q is from 2 to 12, preferably 2 to 6, and more preferably 2 to 3.

The organic diamine compounds with two primary amine moieties can be described as the binary chelating agents.

The organic diamine molecules with other molecular structures can be also used as a chelating agent in the CMP slurries.

The organic diamine molecules with structure (e) is shown below.

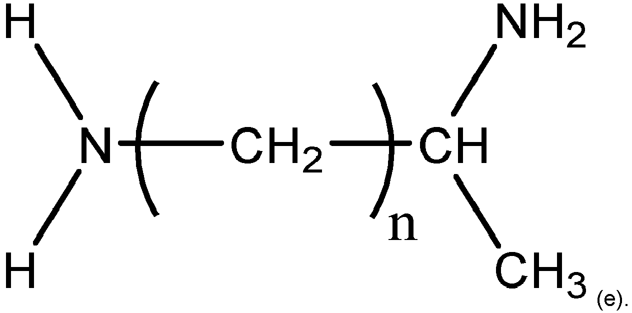

The organic diamines have one terminal primary amine functional group at one end and another primary organic amine attached to the beta carbon atoms on the other end of the molecules.

There can be a secondary primary amine functional groups bonded to the other carbon atoms at other positions, such as gamma etc. and the first primary amine function group still maintains as the terminal primary amine functional group in the same molecules.

n is numbered from 2 to 12.

The organic amine with structure (f) is shown below.

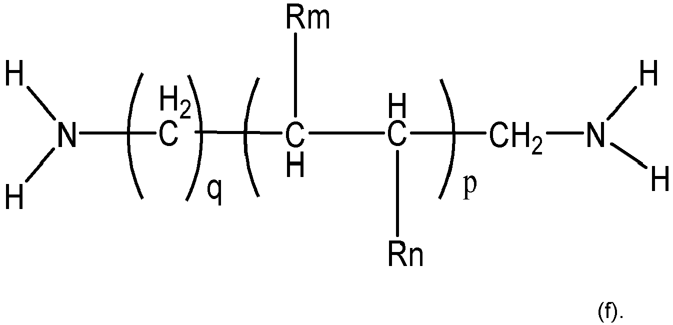

Rn and Rm can be the same or different alkyl groups Rn = CₙH₂ₙ₊₁ and Rm = CₘH₂ₘ₊₁, n is from 1 to 12, preferably 1 to 6, and more preferably 1 to 3; m is from 1 to 12, preferably 1 to 6, and more preferably 1 to 3.

q is from 1 to 6, preferably 1 to 4, and more preferably 1 to 3.

p is from is from 1 to 12, preferably 1 to 6, and more preferably 1 to 3.

The organic amine with structure (g) is shown below.

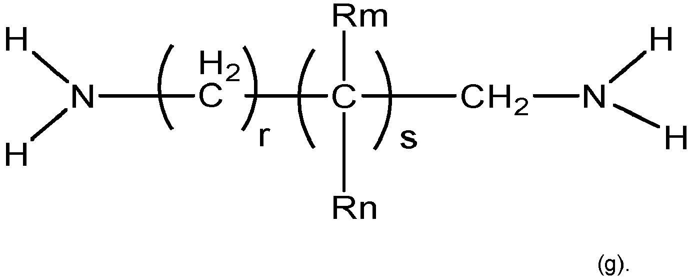

Rn and Rm groups are bonded to the same carbon atom. Rn can be H or an alkyl group = CₙH₂ₙ₊₁, preferably an alkyl. Rm is an alkyl group = CₘH₂ₘ₊₁. Rn and Rm can be the same or different alkyl groups Rn = CₙH₂ₙ₊₁ and Rm = CₘH₂ₘ₊₁, n is from 1 to 12, preferably 1 to 6, and more preferably 1 to 3; m is from 1 to 12, preferably 1 to 6, and more preferably 1 to 3.

r is from 1 to 6, preferably 1 to 4, and more preferably 1 to 3.

s is from 1 to 12, preferably 1 to 6, and more preferably 1 to 3.

Examples include but are not limited to 2-methyl-propanediamine, 2-methyl-butanediamine, 2,2-dimethyl-1,3-propanediamine, and 2,3-dimethyl-2,3-butanediamine, 2-dimethyl-propanediamine, 2,2-dimethyl-butanediamine, 2,3-dimethyl-butane-1,4-diamine, 2,3-dimethyl-pentane-1,5-diamine, and 2,2-dimethyl-1,4-butanediamine.

Any aromatic organic molecules with two primary amine functional groups can be used as one of the chelating agents in the invented Cu CMP slurries.

For example, aromatic organic amines have the general molecular structures as depicted in (h) and (i) as shown below: 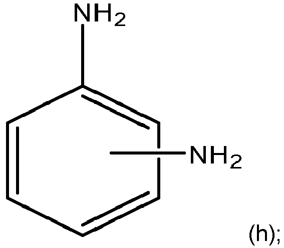 and

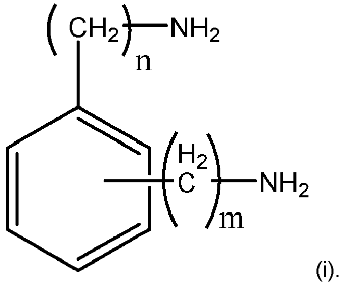

In structure (i), n and m can be the same or different and can be from 1 to 12.

The organic quaternary ammonium salt, includes but is not limited to choline salt, such as choline bicarbonate salt, or all other salts formed between choline and other anionic counter ions.

The choline salts can have the general molecular structures shown below: 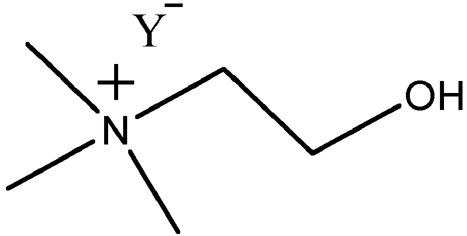 wherein anion Y⁻ can be bicarbonate, hydroxide, p-toluene-sulfonate, bitartate, and other suitable anionic counter ions.

### DETAILED DESCRIPTION OF THE INVENTION

As industry standards trend toward smaller device features, there is a continuously developing need for new Cu bulk metal polishing slurries that afford high and tunable Cu removal rates for the broad and advanced node applications.

The copper bulk CMP or Through Silicon Via (TSV) polishing compositions described herein satisfy the need for high and tunable Cu film removal rates, for high selectivity between copper and dielectric films, for high selectivity between copper and barrier films, and for better Cu film corrosion protection through using the suitable corrosion inhibitors.

The CMP polishing compositions comprise abrasive;
a) oxidizing agent;
b) at least two chelators; and
c) water;
   optionally
d) corrosion inhibitor;
e) organic quaternary ammonium salt;
f) biocide; and
g) pH adjusting agent;
wherein
the at least two chelators are independently selected from the group consisting of amino acids, amino acid derivatives, organic amine, and combinations therefor; wherein at least one chelator is an amino acid or an amino acid derivative; and
the pH of the composition is from 3.0 to 12.0; preferably from 5.5 to 7.5; and more preferably from 7.0 to 7.35;

The Cu CMP polishing compositions provide high and tunable Cu removal rates, and low barrier film and dielectric film removal rates which provide very high and desirable selectivity of Cu film vs. other barrier films, such as Ta, TaN, Ti, and TiN, and/or dielectric films, such as TEOS, low-k, and ultra low-k films.

The chemical mechanical polishing compositions also provide no pad stain Cu CMP performances which allow the extended polish pad life and also allow more stable end-point detections.

The abrasive particles used for the disclosed herein Cu bulk CMP polishing compositions include, but are not limited to, colloidal silica or high purity colloidal silica; the colloidal silica particles doped by other metal oxide within lattice of the colloidal silica, such as alumina doped silica particles; colloidal aluminum oxide including alpha-, beta-, and gamma-types of aluminum oxides; colloidal and photoactive titanium dioxide, cerium oxide, colloidal cerium oxide, nano-sized inorganic metal oxide particles, such as alumina, titania, zirconia, ceria etc.; nano-sized diamond particles, nano-sized silicon nitride particles; mono-modal, bi-modal, multi-modal colloidal abrasive particles; organic polymer-based soft abrasives, surface-coated or modified abrasives, or other composite particles, and mixtures thereof.

The colloidal silica can be made from silicate salts, the high purity colloidal silica can be made from TEOS or TMOS. The colloidal silica or high purity colloidal silica can have narrow or broad particle size distributions with mono-model or multi-models, various sizes and various shapes including spherical shape, cocoon shape, aggregate shape and other shapes,

The nano-sized particles also can have different shapes, such as spherical, cocoon, aggregate, and others.

The particle size of the abrasives used in the Cu CMP slurries is ranged from 5nm to 500nm, preferred size is ranged from 10nm to 250nm, the more preferred size is ranged from 25nm to 100nm.

The Cu bulk CMP polishing compositions of this invention preferably contain 0.0025 wt.% to 25 wt.% abrasives; the preferred concentration of abrasives ranges from 0.0025 wt.% to 2.5 wt.%. The most preferred concentration of abrasives ranges from 0.005 wt.% to 0.15 wt.%.

The organic quaternary ammonium salt, includes but is not limited to choline salt, such as choline bicarbonate salt, or all other salts formed between choline and other anionic counter ions.

The choline salts can have the general molecular structures shown below: 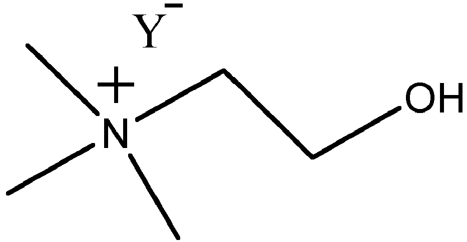 wherein anion Y⁻ can be bicarbonate, hydroxide, p-toluene-sulfonate, bitartate, and other suitable anionic counter ions.

The CMP slurry contains 0.005 wt.% to 0.25 wt.% quaternary ammonium salt; the preferred concentration ranges from 0.001 wt.% to 0.05 wt.%; and the most preferred concentration ranges from 0.002 wt.% to 0.01 wt.%

Various per-oxy inorganic or organic oxidizing agents or other types of oxidizing agents can be used to oxidize the metallic copper film to the mixture of copper oxides to allow their quick reactions with chelating agents and corrosion inhibitors. The oxidizing agent includes, but is not limited to, periodic acid, hydrogen peroxide, potassium iodate, potassium permanganate, ammonium persulfate, ammonium molybdate, ferric nitrate, nitric acid, potassium nitrate, and mixtures thereof. The preferred oxidizer is hydrogen peroxide.

The CMP slurry contains 0.1 wt.% to 10 wt.% oxidizing agents; the preferred concentration ranges from 0.25wt.% to 3wt.%; and the most preferred concentration ranges from 0.5wt.% to 2.0wt.%.

The corrosion inhibitors used for the disclosed copper bulk CMP slurry can be those prior arts reported corrosion inhibitors. The corrosion inhibitors include, but are not limited to family of hetero aromatic compounds containing nitrogen atom(s) in their aromatic rings, such as 1,2,4-triazole, amitrole (or 3-amino-1,2,4-triazole), benzotriazole and benzotriazole derivatives, imidazole and imidazole derivatives, benzimidazole and benzimidazole derivatives, pyrazole and pyrazole derivatives, and tetrazole and tetrazole derivatives.

The CMP slurry contains 0.005 wt.% to 1.0 wt.% corrosion inhibitor; the preferred concentration ranges from 0.01 wt.% to 0.5 wt.%; and the most preferred concentration ranges from 0.025 wt.% to 0.25 wt.%.

A biocide having active ingredients for providing more stable shelf time of the invented Cu chemical mechanical polishing compositions can be used.

Suitable biocides includes but is not limited to Kathon™, Kathon™ CG/ICP II, from Dow Chemical Co. The biocide may contain active ingredients of 5-chloro-2-methyl-4-isothiazolin-3-one and 2-methyl-4-isothiazolin-3-one.

The CMP slurry contains 0.0001 wt.% to 0.05 wt.% biocide; the preferred concentration ranges from 0.0001 wt.% to 0.025 wt.%; and the most preferred concentration ranges from 0.0001 wt.% to 0.01 wt.%.

Optionally, acidic or basic compounds or pH adjusting agents can be used to allow pH of Cu bulk CMP polishing compositions being adjusted to the optimized pH value,

The pH adjusting agents include, but are not limited to, the following: nitric acid, hydrochloric acid, sulfuric acid, phosphoric acid, other inorganic or organic acids, and mixtures thereof. pH adjusting agents also include the basic pH adjusting agents, such as sodium hydroxide, potassium hydroxide, ammonium hydroxide, tetraalkyl ammonium hydroxide, organic amines, and other chemical reagents that are able to be used to adjust pH towards the more alkaline direction.

The CMP slurry contains 0 wt.% to 1 wt.% pH adjusting agent; the preferred concentration ranges from 0.01 wt.% to 0.5 wt.%; and the most preferred concentration ranges from 0.1 wt.% to 0.25 wt.%.

pH of the Cu polishing compositions is from about 3.0 to about 12.0; preferred pH range is from 5.5 to 7.5; and the most preferred pH range is from 7.0 to 7.35.

The CMP slurry contains 0.1 wt.% to 18 wt.% of at least two chelators; the preferred concentration ranges for the sum of at least two used chelators are from 0.5 wt.% to 15 wt.%; and the most preferred concentration ranges for the sum of at least two used chelators are from 2.0 wt.% to 10.0 wt.%.

The at least two chelators are selected independently from the group consisting of amino acids, amino acid derivatives, organic amine, and combinations thereof, wherein the at least one chelator is an amino acid or an amino acid derivative; and at least one chelator is organic amine .

The at least two chelators can be combinations of at least one amino acid with at least one organic amine, combinations of at least one amino acid with at least one amino derivative and at least one organic amine. As an example, the two chelators can be glycine, and ethylenediamine.

The at least two chelators used as complexing agents to maximize their reactions with the oxidized Cu film surfaces to form softer Cu-chelator layers to be quickly removed during Cu CMP process thus achieving high and tunable Cu removal rates for the broad or advanced node copper or TSV (Through Silicon Via) CMP applications.

The amino acids and amino acid derivatives included, but not limited to, glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, etc. Preferably the amino acid selected from the group consisting of glycine, D-alanine, L-alanine, DL-alanine, beta-alanine, and combination thereof. Preferably the amino acid is glycine or alanine.

The organic amines chelators have general molecular structures (a) to (i), as depicted below.

The organic amine with structure (a) has two primary amine functional groups as terminal groups on both ends of the molecule.

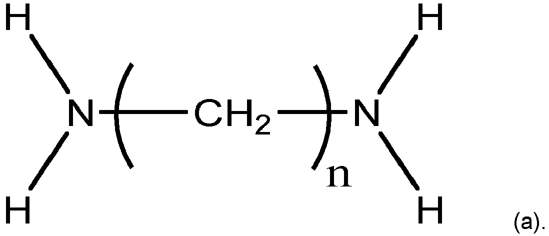

n is numbered from 2 to 12.

For examples, the organic amine is ethylenediamine, 1,3-propanediamine or 1,4-butanediamine as n=2, 3 or 4.

The organic amine with structure (b) also has two primary amine functional groups as terminal groups on both ends of the molecule.

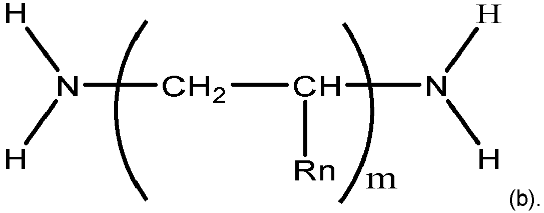

An alkyl group links the two terminal primary amine functional groups. The alkyl group Rn = CₙH₂ₙ₊₁, n is from 1 to 12, preferably 1 to 6, and more preferably 1 to 3.

m can be numbered from 2 to 12.

The linking alkyl group Rn between two terminal primary amine functional groups can also be a branched alkyl group.

The organic amine with structure (c) is shown below.

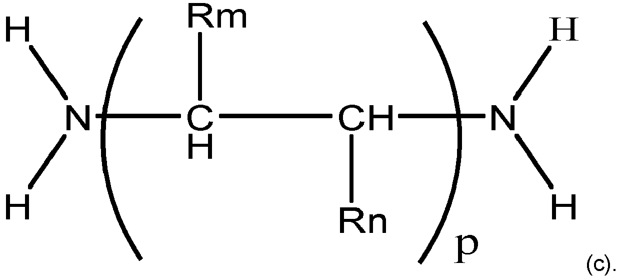

Rn and Rm can be the same or different alkyl groups Rn = CₙH₂ₙ₊₁ and Rm = CₘH₂ₘ₊₁, n or m is from 1 to 12, preferably 1 to 6, and more preferably 1 to 3.

p is from is from 2 to 12, preferably 2 to 6, and more preferably 2 to 3.

The organic amine with structure (d) is shown below.

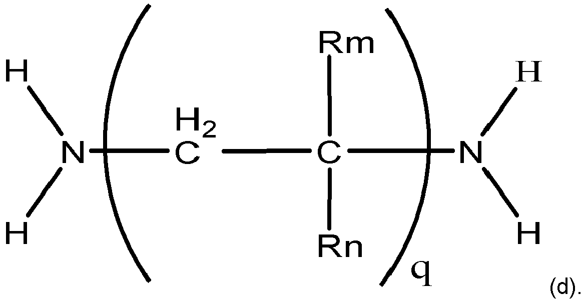

Rn and Rm groups are bonded to the same carbon atom. Rn and Rm can be the same or different alkyl groups Rn = CₙH₂ₙ₊₁ and Rm = CₘH₂ₘ₊₁, n or is from 1 to 12, preferably 1 to 6, and more preferably 1 to 3.

q is from 2 to 12, preferably 2 to 6, and more preferably 2 to 3.

The organic diamine compounds with two primary amine moieties can be described as the binary chelating agents.

The organic diamine molecules with other molecular structures can be also used as a chelating agent in the CMP slurries.

The organic diamine molecules with structure (e) is shown below.

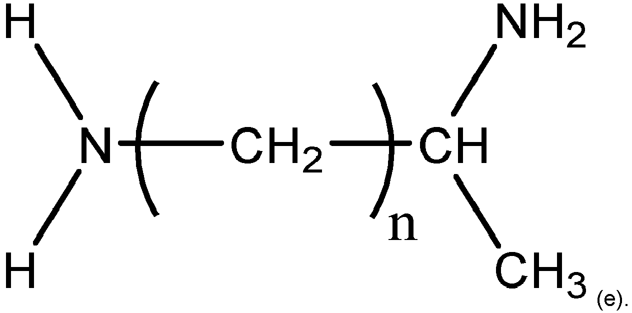

The organic diamines have one terminal primary amine functional group at one end and another primary organic amine attached to the beta carbon atoms on the other end of the molecules.

There can be a secondary primary amine functional groups bonded to the other carbon atoms at other positions, such as gamma etc. and the first primary amine function group still maintains as the terminal primary amine functional group in the same molecules.

n is numbered from 2 to 12.

The organic amine with structure (f) is shown below.

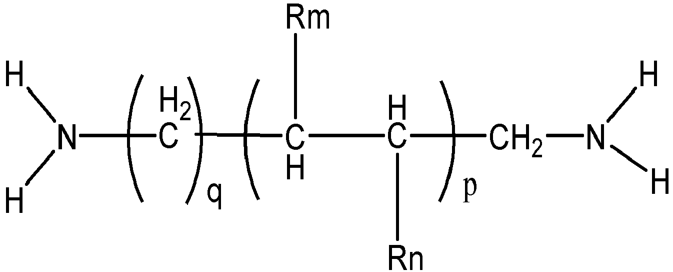

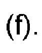

Rn and Rm can be the same or different alkyl groups Rn = CₙH₂ₙ₊₁ and Rm = CₘH₂ₘ₊₁, n or m is from 1 to 12, preferably 1 to 6, and more preferably 1 to 3.

q is from 1 to 6, preferably 1 to 4, and more preferably 1 to 3.

p is from is from 1 to 12, preferably 1 to 6, and more preferably 1 to 3.

The organic amine with structure (g) is shown below.

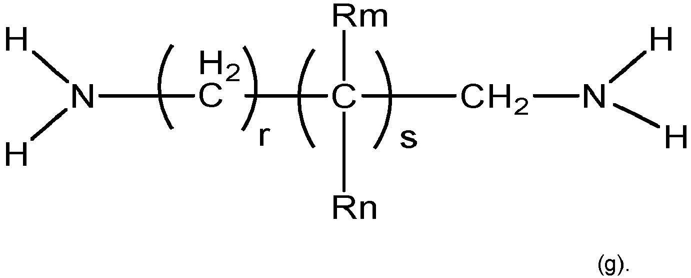

Rn and Rm groups are bonded to the same carbon atom. Rn is H or an alkyl group CₙH₂ₙ₊₁. Rn and Rm can be the same or different alkyl groups Rn = CₙH₂ₙ₊₁ and Rm = CₘH₂ₘ₊₁, n or m is from 1 to 12, preferably 1 to 6, and more preferably 1 to 3.

r is from 1 to 6, preferably 1 to 4, and more preferably 1 to 3.

s is from 1 to 12, preferably 1 to 6, and more preferably 1 to 3.

Examples include but are not limited to 2-methyl-propanediamine, 2-methyl-butanediamine, 2,2-dimethyl-1,3-propanediamine, and 2,3-dimethyl-2,3-butanediamine, 2-dimethyl-propanediamine, 2,2-dimethyl-butanediamine, 2,3-dimethyl-butane-1,4-diamine, 2,3-dimethyl-pentane-1,5-diamine, and 2,2-dimethyl-1,4-butanediamine.

Any aromatic organic molecules with two primary amine functional groups can be used as one of the chelating agents in the invented Cu CMP slurries.

For example, aromatic organic amines have the general molecular structures as depicted in (h) and (i) as shown below: 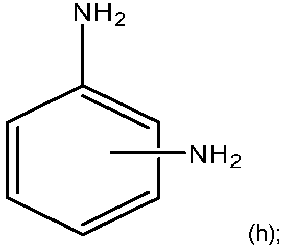 and

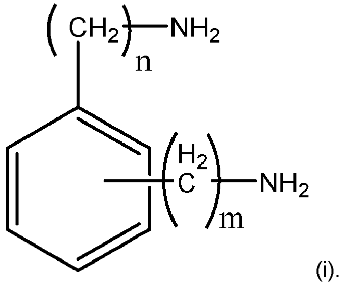

In structure (i), n and m can be the same or different and can be from 1 to 12.

As used herein "alkyl" refers to a linear or branched alkyl group containing 1,2,3,4,5,6,7,8,9,10,11 or 12 carbon atoms. Examples of suitable alkyl groups include methyl, ethyl, propyl, tert-butyl, tert-amyl, iso-butyl, and iso-propyl.

Preferably, the organic amine is selected from the group consisting of ethylenediamine, 1,3-propanediamine, 1,4-butanediamine, 2-methyl-propanediamine, 2-methyl-butanediamine, 2,2-dimethyl-1,3-propanediamine, 2,3-dimethyl-2,3-butanediamine, 2,2-dimethyl-propanediamine and 2,2-dimethyl-butanediamine, 2,3-dimethyl-butane-1,4-diamine, and 2,3-dimethyl-pentane-1,5-diamine, and 2,2-dimethyl-1,4-butanediamine, and the combinations thereof. More preferably the at least one organic amine selected from ethylenediamine, propylenediamine, and butylenediamine.

The associated methods and systems described herein entail use of the aforementioned compositions for chemical mechanical planarization of substrates comprised of copper.

In the methods, a substrate (e.g., a wafer or substrate with Cu or Cu containing surface or Cu plug) is placed face-down on a polishing pad which is fixedly attached to a rotatable platen of a CMP polisher. In this manner, the substrate to be polished and planarized is placed in direct contact with the polishing pad. A wafer carrier system or polishing head is used to hold the substrate in place and to apply a downward pressure against the backside of the substrate during CMP processing while the platen and the substrate are rotated. The polishing composition (slurry) is applied (usually continuously) on the pad during CMP processing to effect the removal of material to planarize the substrate.

The polishing composition and associated methods as well as systems described herein are effective for CMP of a wide variety of substrates, including most of substrates having copper surfaces, or copper substrates.

The present invention includes the following Aspects 1 to 22:
Aspect 1. A copper chemical mechanical polishing (CMP) composition comprising:
   a) abrasive;
   b) at least two chelators;
   c) oxidizing agent; and
   d) water;
      optionally
   e) corrosion inhibitor;
   f) organic quaternary ammonium salt;
   g) biocide;
   h) pH adjusting agent;
   wherein
   the at least two comprise (1) at least one organic amine; and (2) one selected from the group consisting of at least one amino acid, at least one amino acid derivative, and combinations thereof;
   the organic quaternary ammonium salt is selected from the group consisting of choline salt, salt formed between choline and other anionic counter ions, and combinations thereof; and
   the pH of the composition is selected from the group consisting of 5.5 to 7.5; and 7.0 to 7.35.
Aspect 2. The copper chemical mechanical polishing (CMP) composition of Aspect 1, wherein the at least two chelators comprise (1) at least one organic amine; and (2) one selected from the group consisting of at least one amino acid, at least one derivative, and combinations of at least one amino acid with at least one amino derivative.
Aspect 3. The copper chemical mechanical polishing (CMP) composition of Aspect 1, wherein
   the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof; and
   the organic amine has a general molecular structure selected from the group consisting of: 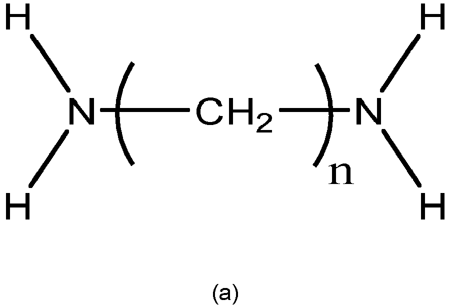
      wherein n is from 2 to 12; 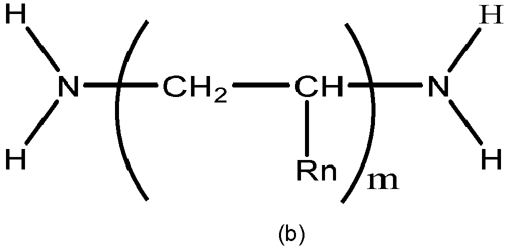
      wherein Rn represents an organic alkyl group CₙH₂ₙ₊₁, n is selected from the group consisting of 2 to 12, 1 to 6, and 1 to 3; and m is from 2 to 12; 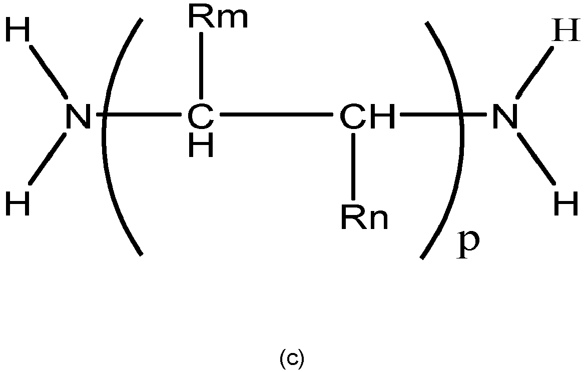
      wherein Rn and Rm can be the same or different alkyl groups with n and m numbered independently from 1 to 12;
      wherein Rn and Rm can be the same or different alkyl groups Rn = CₙH₂ₙ₊₁ and Rm = CₘH₂ₘ₊₁, n and m is independently selected from the group consisting of 2 to 12, 1 to 6, and 1 to 3; and p is from 2 to 12; 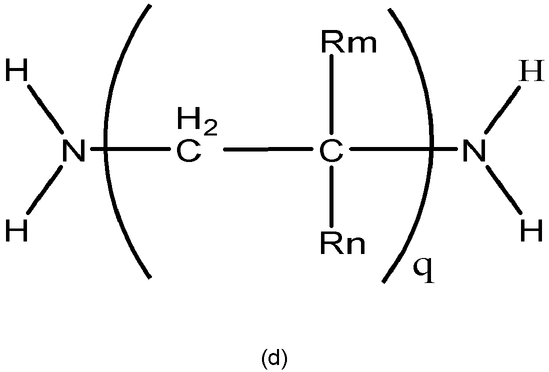
      wherein Rn and Rm can be the same or different alkyl groups Rn = CₙH₂ₙ₊₁ and Rm = CₘH₂ₘ₊₁, n and m is independently selected from the group consisting of 2 to 12, 1 to 6, and 1 to 3; and q is from 2 to 12; 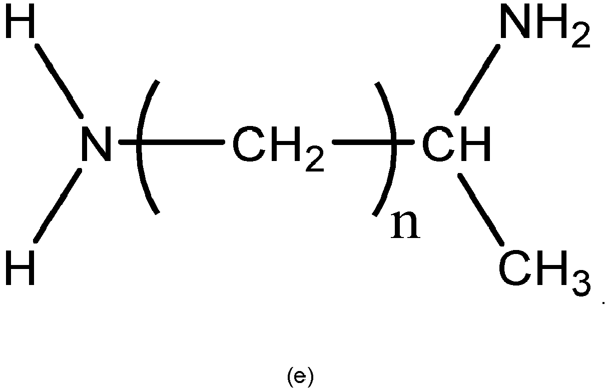
      wherein n is from 1 to 12; 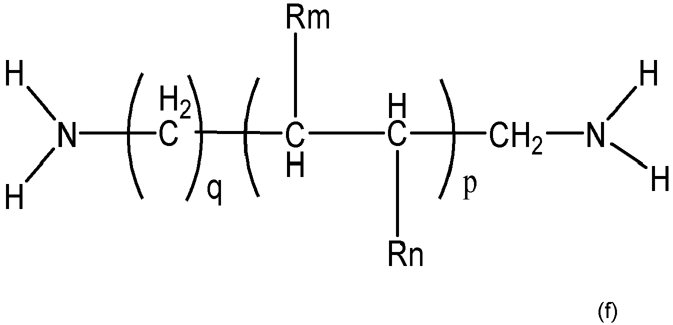
      wherein Rn and Rm can be the same or different alkyl groups Rn = CₙH₂ₙ₊₁ and Rm = CₘH₂ₘ₊₁, n and m is independently selected from the group consisting of 1 to 12, 1 to 6, and 1 to 3; p is selected from the group consisting of 1 to 12, 1 to 6, and 1 to 3; and q is from is selected from the group consisting of 1 to 6, 1 to 4, and 1 to 3; 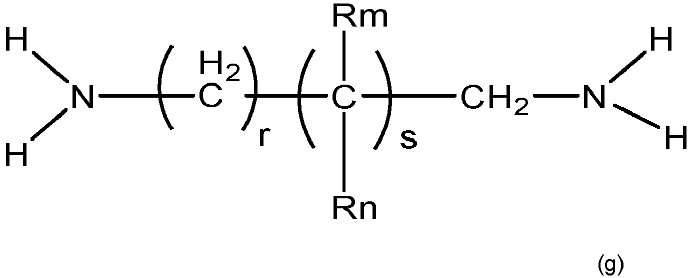
      wherein Rn and Rm are bonded to the same carbon atom and can be the same or different alkyl groups Rn =H or CₙH₂ₙ₊₁ and Rm = CₘH₂ₘ₊₁, n and m is independently selected from the group consisting of 1 to 12, 1 to 6, and 1 to 3; s is selected from the group consisting of 1 to 12, 1 to 6, and 1 to 3; and r is from is selected from the group consisting of 1 to 6, 1 to 4, and 1 to 3; 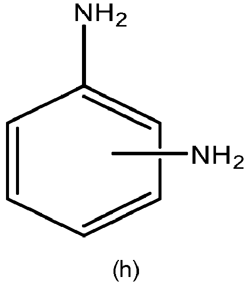 and 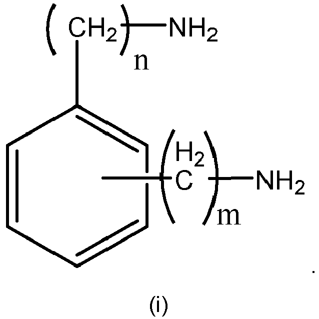
      wherein n and m is numbered independently from 1 to 12 ;
      and combinations thereof.
Aspect 4. The copper chemical mechanical polishing (CMP) composition of Aspect 1, wherein
   the choline salt has a general molecular structure shown below: 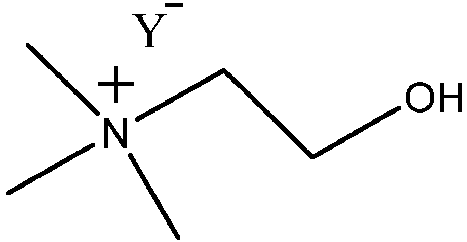
   wherein anion Y⁻ can be bicarbonate, hydroxide, p-toluene-sulfonate, or bitartate; the corrosion inhibitor is selected from the group consisting of 1,2,4-triazole, benzotriazole and benzotriazole derivatives, imidazole and imidazole derivatives, benzimidazole and benzimidazole derivatives, pyrazole and pyrazole derivatives, tetrazole and tetrazole derivatives, and combinations thereof;
   the oxidizing agent is selected from the group consisting of periodic acid, hydrogen peroxide, potassium iodate, potassium permanganate, ammonium persulfate, ammonium molybdate, ferric nitrate, nitric acid, potassium nitrate, and combinations thereof;
   the biocide has an active ingredient selected from the group consisting of 5-chloro-2-methyl-4-isothiazolin-3-one, 2-methyl-4-isothiazolin-3-one, and combinations thereof; and
   the pH adjusting agent is either (1) selected from the group consisting of nitric acid, hydrochloric acid, sulfuric acid, phosphoric acid, and combinations thereof for adjusting pH toward acidic; or (2) selected from the group consisting of sodium hydride, potassium hydroxide, ammonium hydroxide, tetraalkyl ammonium hydroxide, organic amine, and combinations thereof for adjusting pH toward alkaline.
Aspect 5. The copper chemical mechanical polishing (CMP) composition of Aspect 1, wherein
   the organic amine is selected from the group consisting of ethylenediamine, 1,3-propanediamine, 1,4-butanediamine, 2-methyl-propanediamine, 2-methyl-butanediamine, 2,2-dimethyl-1,3-propanediamine, 2,3-dimethyl-2,3-butanediamine, 2,2-dimethyl-propanediamine and 2,2-dimethyl-butanediamine, 2,3-dimethyl-butane-1,4-diamine, and 2,3-dimethyl-pentane-1,5-diamine, and 2,2-dimethyl-1,4-butanediamine, and the combinations thereof; and
   the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;
Aspect 6. The copper chemical mechanical polishing (CMP) composition of Aspect 1, comprises
   0.0025 wt.% to 2.5 wt.% of colloidal silica or high purity colloidal silica;
   0.001 to 18.0 total wt. % of (1) at least one of the organic amine selected from the group consisting of ethylenediamine, propylenediamine, and butylenediamine; and (2) at least one of amino acid selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;
   0.001 wt. % to 0.05 wt. % of choline bicarbonate salt; and
   the composition has a pH from 5.5 to 7.5.
Aspect 7. The copper chemical mechanical polishing (CMP) composition of Aspect 1, comprises
   0.0025 wt.% to 2.5 wt.% of colloidal silica or high purity colloidal silica;
   0.5 to 10.0 total wt. % of (1) at least one organic amine selected from ethylenediamine propylenediamine, and butylenediamine; and (2) at least amino acid selected from the group consisting of glycine, D-alanine, L-alanine, DL-alanine, beta-alanine, and combination thereof;
   0.001 wt. % to 0.05 wt. % of choline bicarbonate salt; and
   the composition has a pH from 5.5 to 7.5.
Aspect 8. The copper chemical mechanical polishing (CMP) composition of Aspect 1, comprising
   0.0005 wt.% to 0.15 wt.% of colloidal silica or high purity colloidal silica;
   0.5 to 10.0 total wt. % of ethylenediamine; glycine or alanine;
   0.002 wt. % to 0.01 wt. % of choline bicarbonate salt;
   0.5 wt. % to 3.0 wt. % of periodic acid or hydrogen peroxide;
   0.001 wt. % to 0.5 wt. % of 3-amino-1,2,4-triazole, 1,2,4-triazole, or benzotriazole and benzotriazole derivatives;
   0.0001 wt.% to 0.025 wt.% of the biocide having an active ingredient selected from the group consisting of 5-chloro-2-methyl-4-isothiazolin-3-one, 2-methyl-4-isothiazolin-3-one, and combinations thereof; and
   the composition has a pH from 7.0 to 7.35.
Aspect 9. A method of chemical mechanical polishing a semiconductor substrate having at least one surface comprising copper (Cu) or copper-containing material and at least one second material; comprising steps of:
   1) providing the semiconductor substrate;
   2) providing a polish pad;
   3) providing a Cu chemical mechanical polishing composition comprising:
      a) abrasive;
      b) at least two chelators;
      c) oxidizing agent; and
      d) water;
         optionally
      e) corrosion inhibitor;
      f) organic quaternary ammonium salt;
      g) biocide;
      h) pH adjusting agent;
      wherein
      the at least two chelators comprise (1) at least one organic amine; and (2) one selected from the group consisting of at least one amino acid, at least one amino acid derivative, and combinations thereof;
      the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof; and
      the organic amine has a general molecular structure selected from the group consisting of: 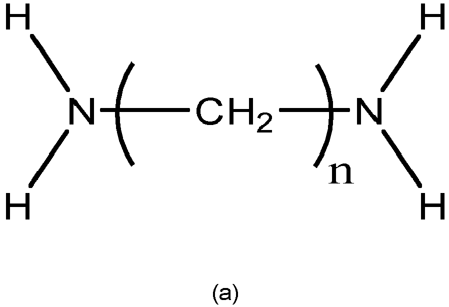 wherein n is from 2 to 12; 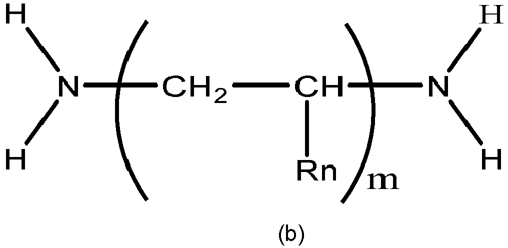
      wherein Rn represents an organic alkyl group CₙH₂ₙ₊₁, n is selected from the group consisting of 2 to 12, 1 to 6, and 1 to 3; and m is from 2 to 12; 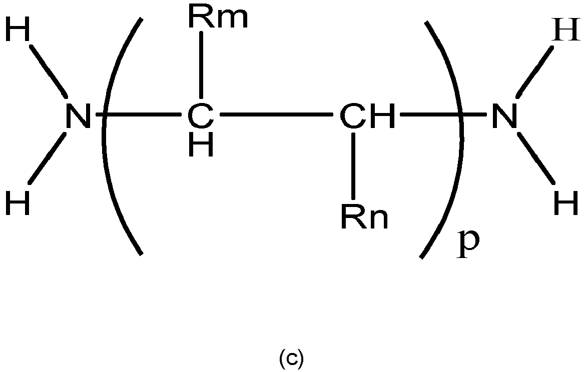
      wherein Rn and Rm can be the same or different alkyl groups with n and m numbered independently from 1 to 12;
      wherein Rn and Rm can be the same or different alkyl groups Rn = CₙH₂ₙ₊₁ and Rm = CₘH₂ₘ₊₁, n and m is independently selected from the group consisting of 2 to 12, 1 to 6, and 1 to 3; and p is from 2 to 12; 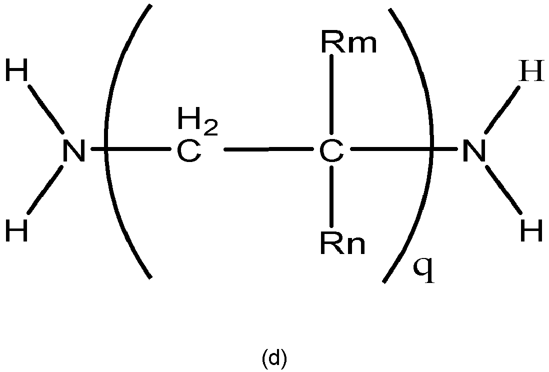
      wherein Rn and Rm can be the same or different alkyl groups Rn = CₙH₂ₙ₊₁ and Rm = CₘH₂ₘ₊₁, n and m is independently selected from the group consisting of 2 to 12, 1 to 6, and 1 to 3; and q is from 2 to 12; 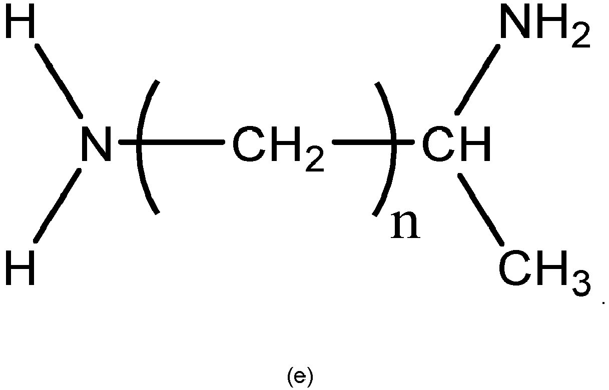 wherein n is from 1 to 12;
      wherein n is from 1 to 12; 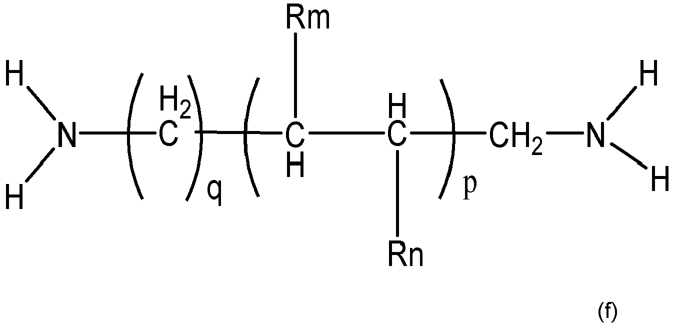
      wherein Rn and Rm can be the same or different alkyl groups Rn = CₙH₂ₙ₊₁ and Rm = CₘH₂ₘ₊₁, n and m is independently selected from the group consisting of 1 to 12, 1 to 6, and 1 to 3; p is selected from the group consisting of 1 to 12, 1 to 6, and 1 to 3; and q is from is selected from the group consisting of 1 to 6, 1 to 4, and 1 to 3; 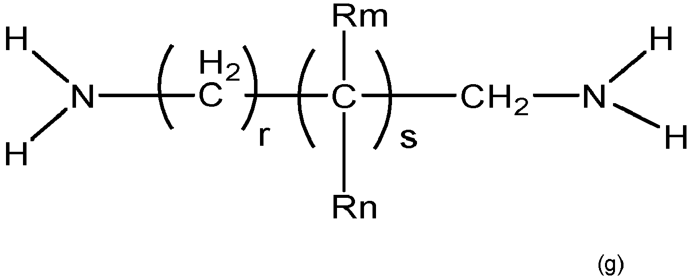
      wherein Rn and Rm are bonded to the same carbon atom and can be the same or different alkyl groups Rn = H or CₙH₂ₙ₊₁ and Rm = CₘH₂ₘ₊₁, n and m is independently selected from the group consisting of 1 to 12, 1 to 6, and 1 to 3; s is selected from the group consisting of 1 to 12, 1 to 6, and 1 to 3; and r is from is selected from the group consisting of 1 to 6, 1 to 4, and 1 to 3; 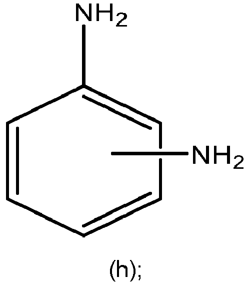 and 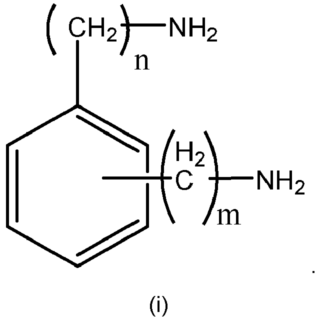
         wherein n and m is numbered independently from 1 to 12 ;
         and combinations thereof;
      the organic quaternary ammonium salt is selected from the group consisting of choline salt, salt formed between choline and other anionic counter ions, and combinations thereof;
      and
      the pH of the composition is selected from the group consisting of 5.5 to 7.5; and 7.0 to 7.35;
   4) contacting the at least one surface with the polish pad and the Cu chemical mechanical polishing composition; and
   5) polishing the at least one surface to remove copper or copper-containing material.
Aspect 10. The method for chemical mechanical polishing of Aspect 9, wherein the choline salt has a general molecular structure shown below: 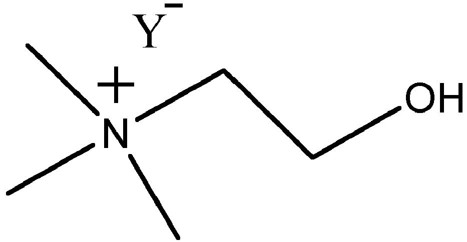
   wherein anion Y⁻ can be bicarbonate, hydroxide, p-toluene-sulfonate, or bitartate; the corrosion inhibitor is selected from the group consisting of 1,2,4-triazole, benzotriazole and benzotriazole derivatives, imidazole and imidazole derivatives, benzimidazole and benzimidazole derivatives, pyrazole and pyrazole derivatives, tetrazole and tetrazole derivatives, and combinations thereof;
   the oxidizing agent is selected from the group consisting of periodic acid, hydrogen peroxide, potassium iodate, potassium permanganate, ammonium persulfate, ammonium molybdate, ferric nitrate, nitric acid, potassium nitrate, and combinations thereof;
   the biocide has an active ingredient selected from the group consisting of 5-chloro-2-methyl-4-isothiazolin-3-one, 2-methyl-4-isothiazolin-3-one, and combinations thereof; and
   the pH adjusting agent is either (1) selected from the group consisting of nitric acid, hydrochloric acid, sulfuric acid, phosphoric acid, and combinations thereof for adjusting pH toward acidic; or (2) selected from the group consisting of sodium hydroxide, potassium hydroxide, ammonium hydroxide, tetraalkyl ammonium hydroxide, organic amine, and combinations thereof for adjusting pH toward alkaline.
Aspect 11. The method for chemical mechanical polishing of Aspect 9, wherein
   the organic amine is selected from the group consisting of ethylenediamine, 1,3-propanediamine, 1,4-butanediamine, 2-methyl-propanediamine, 2-methyl-butanediamine, 2,2-dimethyl-1,3-propanediamine, 2,3-dimethyl-2,3-butanediamine, 2,2-dimethyl-propanediamine and 2,2-dimethyl-butanediamine, 2,3-dimethyl-butane-1,4-diamine, and 2,3-dimethyl-pentane-1,5-diamine, and 2,2-dimethyl-1,4-butanediamine, and the combinations thereof;
      and
   the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;
Aspect 12. The method for chemical mechanical polishing of Aspect 9, wherein the Cu chemical mechanical polishing composition comprises
   0.0025 wt.% to 2.5 wt.% of colloidal silica or high purity colloidal silica;
   0.001 to 18.0 total wt. % of (1) at least one of the organic amine selected from the group consisting of ethylenediamine, propylenediamine, and butylenediamine; and (2) at least one of amino acid selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;
   0.001 wt. % to 0.05 wt. % of choline bicarbonate salt; and
   the composition has a pH from 5.5 to 7.5.
Aspect 13. The method for chemical mechanical polishing of Aspect 9, wherein the Cu chemical mechanical polishing composition comprises
   0.0025 wt.% to 2.5 wt.% of colloidal silica or high purity colloidal silica;
   0.5 to 10.0 total wt. % of (1) at least one organic amine selected from ethylenediamine propylenediamine, and butylenediamine; and (2) at least amino acid selected from the group consisting of glycine, D-alanine, L-alanine, DL-alanine, beta-alanine, and combination thereof;
   0.001 wt. % to 0.05 wt. % of choline bicarbonate salt; and
   the composition has a pH from 5.5 to 7.5.
Aspect 14. The method for chemical mechanical polishing of Aspect 9, wherein the Cu chemical mechanical polishing composition comprises
   0.0005 wt.% to 0.15 wt.% of colloidal silica or high purity colloidal silica;
   0.5 to 10.0 total wt. % of ethylenediamine; glycine or alanine;
   0.002 wt. % to 0.01 wt. % of choline bicarbonate salt;
   0.5 wt. % to 3.0 wt. % of periodic acid or hydrogen peroxide;
   0.001 wt. % to 0.5 wt. % of 3-amino-1,2,4-triazole, 1,2,4-triazole, or benzotriazole and benzotriazole derivatives;
   0.0001 wt.% to 0.025 wt.% of the biocide having an active ingredient selected from the group consisting of 5-chloro-2-methyl-4-isothiazolin-3-one, 2-methyl-4-isothiazolin-3-one, and combinations thereof; and
   the composition has a pH from 7.0 to 7.35.
Aspect 15. The method for chemical mechanical polishing of Aspect 9, wherein the second material is selected from the group consisting of barrier layer selected from the group consisting of Ta, TaN, Ti, and TiN film; dielectric layer selected from the group consisting of TEOS, low-k; and ultra low-k film; and removal rate of Cu vs removal rate of the second material is equal or greater than 500:1.
Aspect 16. A system for chemical mechanical polishing a semiconductor substrate having at least one surface comprising copper (Cu) or copper-containing material and at least one second material; comprising steps of:
   1) providing the semiconductor substrate;
   2) providing a polish pad;
   3) providing a Cu chemical mechanical polishing composition comprising:
      a) abrasive;
      b) at least two chelators;
      c) oxidizing agent; and
      d) water;
         optionally
      e) corrosion inhibitor;
      f) organic quaternary ammonium salt;
      g) biocide;
      h) pH adjusting agent;
      wherein
      the at least two chelators comprise (1) at least one organic amine; and (2) one selected from the group consisting of at least one amino acid, at least one amino acid derivative, and combinations thereof;
      the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof; and
      the organic amine has a general molecular structure selected from the group consisting of: 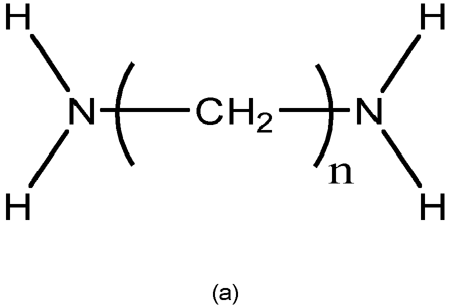 wherein n is from 2 to 12; 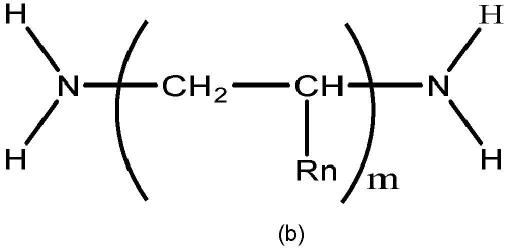
      wherein Rn represents an organic alkyl group CₙH₂ₙ₊₁, n is selected from the group consisting of 2 to 12, 1 to 6, and 1 to 3; and m is from 2 to 12; 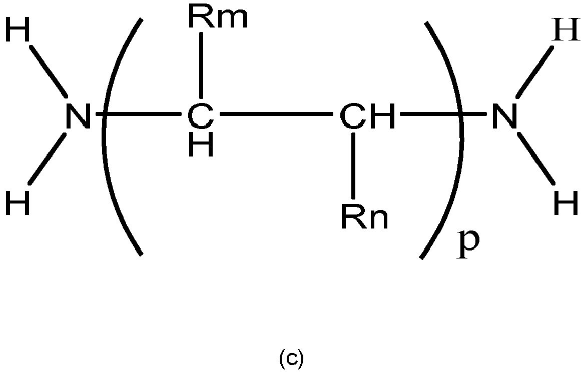
      wherein Rn and Rm can be the same or different alkyl groups with n and m numbered independently from 1 to 12;
      wherein Rn and Rm can be the same or different alkyl groups Rn = CₙH₂ₙ₊₁ and Rm = CₘH₂ₘ₊₁, n and m is independently selected from the group consisting of 2 to 12, 1 to 6, and 1 to 3; and p is from 2 to 12; 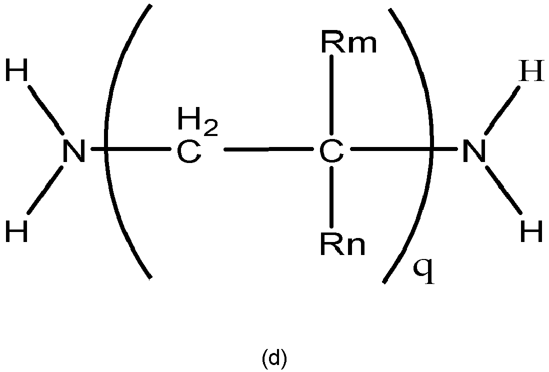
      wherein Rn and Rm can be the same or different alkyl groups Rn = CₙH₂ₙ₊₁ and Rm = CₘH₂ₘ₊₁, n and m is independently selected from the group consisting of 2 to 12, 1 to 6, and 1 to 3; and q is from 2 to 12; 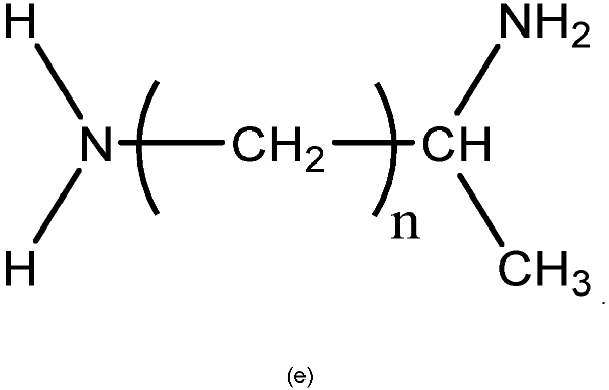 wherein n is from 1 to 12; 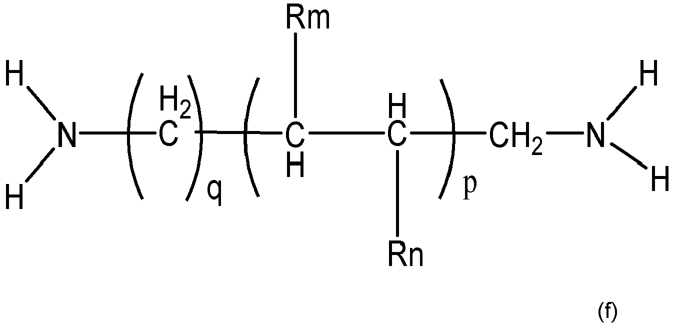
         wherein Rn and Rm can be the same or different alkyl groups Rn = CₙH₂ₙ₊₁ and Rm = CₘH₂ₘ₊₁, n and m is independently selected from the group consisting of 1 to 12, 1 to 6, and 1 to 3; p is selected from the group consisting of 1 to 12, 1 to 6, and 1 to 3; and q is from is selected from the group consisting of 1 to 6, 1 to 4, and 1 to 3; 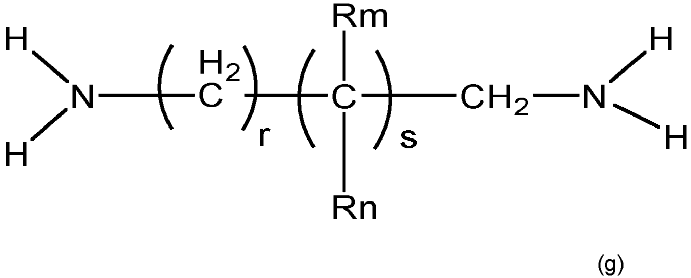
         wherein Rn and Rm are bonded to the same carbon atom and can be the same or different alkyl groups Rn = H or CₙH₂ₙ₊₁ and Rm = CₘH₂ₘ₊₁, n and m is independently selected from the group consisting of 1 to 12, 1 to 6, and 1 to 3; s is selected from the group consisting of 1 to 12, 1 to 6, and 1 to 3; and r is from is selected from the group consisting of 1 to 6, 1 to 4, and 1 to 3; 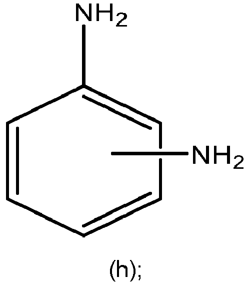 and 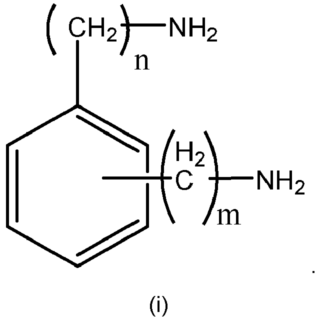
            wherein n and m is numbered independently from 1 to 12;
            and combinations thereof;
      the organic quaternary ammonium salt is selected from the group consisting of choline salt, salt formed between choline and other anionic counter ions, and combinations thereof;
      and
      the pH of the composition is selected from the group consisting of 5.5 to 7.5; and 7.0 to 7.35;
   wherein at least a portion of the at least one surface comprising copper (Cu) or copper-containing material and at least one second material is in contact with both the polishing pad and the Cu chemical mechanical polishing composition.
Aspect 17. The system of Aspect 16, wherein the choline salt has a general molecular structure shown below: 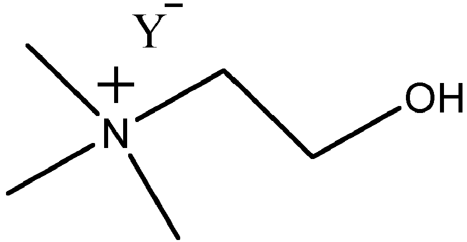
   wherein anion Y⁻ can be bicarbonate, hydroxide, p-toluene-sulfonate, or bitartate; the corrosion inhibitor is selected from the group consisting of 1,2,4-triazole, benzotriazole and benzotriazole derivatives, imidazole and imidazole derivatives, benzimidazole and benzimidazole derivatives, pyrazole and pyrazole derivatives, tetrazole and tetrazole derivatives, and combinations thereof;
   the oxidizing agent is selected from the group consisting of periodic acid, hydrogen peroxide, potassium iodate, potassium permanganate, ammonium persulfate, ammonium molybdate, ferric nitrate, nitric acid, potassium nitrate, and combinations thereof;
   the biocide has an active ingredient selected from the group consisting of 5-chloro-2-methyl-4-isothiazolin-3-one, 2-methyl-4-isothiazolin-3-one, and combinations thereof; and
   the pH adjusting agent is either (1) selected from the group consisting of nitric acid, hydrochloric acid, sulfuric acid, phosphoric acid, and combinations thereof for adjusting pH toward acidic; or (2) selected from the group consisting of sodium hydroxide, potassium hydroxide, ammonium hydroxide, tetraalkyl ammonium hydroxide, organic amine, and combinations thereof for adjusting pH toward alkaline.
Aspect 18. The system of Aspect 16, wherein
   the organic amine is selected from the group consisting of ethylenediamine, 1,3-propanediamine, 1,4-butanediamine, 2-methyl-propanediamine, 2-methyl-butanediamine, 2,2-dimethyl-1,3-propanediamine, 2,3-dimethyl-2,3-butanediamine, 2,2-dimethyl-propanediamine and 2,2-dimethyl-butanediamine, 2,3-dimethyl-butane-1,4-diamine, and 2,3-dimethyl-pentane-1,5-diamine, and 2,2-dimethyl-1,4-butanediamine, and the combinations thereof; and
   the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;
Aspect 19. The system of Aspect 16, wherein the Cu chemical mechanical polishing composition comprises
   0.0025 wt.% to 2.5 wt.% of colloidal silica or high purity colloidal silica;
   0.001 to 18.0 total wt. % of (1) at least one of the organic amine selected from the group consisting of ethylenediamine, propylenediamine, and butylenediamine; and (2) at least one of amino acid selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;
   0.001 wt. % to 0.05 wt. % of choline bicarbonate salt; and
      the composition has a pH from 5.5 to 7.5.
Aspect 20. The system of Aspect 16, wherein the Cu chemical mechanical polishing composition comprises
   0.0025 wt.% to 2.5 wt.% of colloidal silica or high purity colloidal silica;
   0.5 to 10.0 total wt. % of (1) at least one organic amine selected from ethylenediamine propylenediamine, and butylenediamine; and (2) at least amino acid selected from the group consisting of glycine, D-alanine, L-alanine, DL-alanine, beta-alanine, and combination thereof;
   0.001 wt. % to 0.05 wt. % of choline bicarbonate salt; and
   the composition has a pH from 5.5 to 7.5.
Aspect 21. The system of Aspect 16, wherein the Cu chemical mechanical polishing composition comprises
   0.0005 wt.% to 0.15 wt.% of colloidal silica or high purity colloidal silica;
   0.5 to 10.0 total wt. % of ethylenediamine; glycine or alanine;
   0.002 wt. % to 0.01 wt. % of choline bicarbonate salt;
   0.5 wt. % to 3.0 wt. % of periodic acid or hydrogen peroxide;
   0.001 wt. % to 0.5 wt. % of 3-amino-1,2,4-triazole, 1,2,4-triazole, or benzotriazole and benzotriazole derivatives;
   0.0001 wt.% to 0.025 wt.% of the biocide having an active ingredient selected from the group consisting of 5-chloro-2-methyl-4-isothiazolin-3-one, 2-methyl-4-isothiazolin-3-one, and combinations thereof; and
   the composition has a pH from 7.0 to 7.35.
Aspect 22. The system of Aspect 16, wherein the second material is selected from the group consisting of barrier layer selected from the group consisting of Ta, TaN, Ti, and TiN film; dielectric layer selected from the group consisting of TEOS, low-k; and ultra low-k film; and removal rate of Cu vs removal rate of the second material is equal or greater than 500:1.

### Experimental Section

| | |
|---|---|
| Polishing Pad | Polishing pad, IC1010 pad or Other polishing pad was used during Cu CMP, supplied by Dow Chemicals Company. |

### PARAMETERS:

Å: angstrom(s) - a unit of length
BP: back pressure, in psi units
CMP: chemical mechanical planarization = chemical mechanical polishing
CS: carrier speed
DF: Down force: pressure applied during CMP, units psi
min: minute(s)
ml: milliliter(s)
mV: millivolt(s)
psi: pounds per square inch
PS: platen rotational speed of polishing tool, in rpm (revolution(s) per minute)
SF: polishing composition flow, ml/min

### Removal Rates

| | |
|---|---|
| Cu RR 1.0 psi | Measured Copper removal rate at 1.0 psi down pressure of the CMP tool |
| Cu RR 2.0 psi | Measured Copper removal rate at 2.0 psi down pressure of the CMP tool |
| Cu RR 3.0 psi | Measured Copper removal rate at 1.0 psi down pressure of the CMP tool |
| Cu RR 4.0 psi | Measured Copper removal rate at 2.0 psi down pressure of the CMP tool |

### General Experimental Procedure

All percentages in the compositions are weight percentages unless otherwise indicated.

In the examples presented below, CMP experiments were run using the procedures and experimental conditions given below. The CMP tool that was used in the examples is a 200mm Mirra® polisher, manufactured by Applied Materials, 3050 Boweres Avenue, Santa Clara, California, 95054. An IC1010 pad or other type of polishing pad, supplied by Dow Chemicals Company was used on the platen for the blanket wafer polishing studies. Pads were broken-in by polishing twenty-five dummy oxide (deposited by plasma enhanced CVD from a TEOS precursor, PETEOS) wafers. In order to qualify the tool settings and the pad break-in, two PETEOS monitors were polished with Syton® OX-K colloidal silica, supplied by Planarization Platform of Air Products Chemicals Inc. at baseline conditions. Polishing experiments were conducted using blanket Cu wafers with 80K Angstroms in thickness, Ta and TEOS blanket wafers. These blanket wafers were purchased from Silicon Valley Microelectronics, 1150 Campbell Ave, CA, 95126.

### Working Example

In this working example, Reference 1 slurry contained 3.78 wt.% (as 1X) single chelator glycine, 0.18915 wt.% (as 1X) of amitrole (or 3-amino-1,2,4-triazole), 0.00963 wt.% (as 1X) of choline bicarbonate (CBC), 0.037575 wt.% (as 1X) of high purity colloidal silica, and 0.0001 wt.% of biocide, and with pH being adjusted to 7.2.

Reference# 2 slurry contained 0.004 wt.% single chelator ethylenediamine (EDA), 0.18915 wt.% of amitrole, 0.00963 wt.% of choline bicarbonate, 0.037575 wt.% of high purity colloidal silica, and 0.0001 wt.% of biocide, and with pH being adjusted to 7.2.

Working composition 1 contained 3.78 wt.% glycine, 0.004 wt.% ethylenediamine, 0.18915 wt.% of amitrole, 0.00963 wt.% of choline bicarbonate, 0.037575 wt.% of high purity colloidal silica, and 0.0001 wt.% of biocide, and with pH being adjusted to 7.2.

All three slurries used 1.5 wt.% of H₂O₂ as oxidizing agent at point of use, respectively. The CMP polishing slurries had a pH at 7.2.

Reference 1 also described as used 1X Glycine, 1X Amitrole, 1X CBC, 1X Silica; Reference 2 described as used 1X EDA, 1X Amitrole, 1X CBC, 1X Silica; and the Working composition described as used 1X Glycine, 1X EDA, 1X Amitrole, 1X CBC, 1X Silica; as shown in the following tables.

### Example 1

The polish results of using the Cu bulk CMP polishing slurries were listed in Table 1 and depicted in Figure 1.

**Table 1. Cu Removal Rate Comparison in High Cu RR Bulk Slurries**

| Compositions | Cu RR (Å/min.) at 2.0psi DF | Cu RR (Å/min.) at 3.0psi DF | Cu RR (Å/min.) at 4.0psi DF |
|---|---|---|---|
| 1X Glycine + 1X Amitrole + 1X CBC + 1X Silica | 16497 | 22316 | 27832 |
| 1X EDA + 1X Amitrole + 1X CBC + 1X Silica | 2455 | 2535 | 2550 |
| 1X Glycine + 1X EDA + 1X Amitrole + 1X CBC + 1X Silica | 17313 | 23759 | 31154 |

As the results shown in Table 1, Cu CMP polishing composition (Working composition 1) afforded higher Cu film removal rates at different down forces when using two chelators while comparting the Cu removal rates obtained only using a single chelator.

Cu removal rates were increased from 2550Å/min. for only using ethylenediamine as the single chelator or 27832Å/min. for only using glycine as a single chelator to 31154Å/min. while using ethylenediamine and glycine as dual chelator at 4.0psi down force.

### Example 2

In this working example, reference 3 slurry contained 3.78 wt.% single chelator alanine, 0.18915 wt.% of amitrole, 0.00963 wt.% of choline bicarbonate, 0.037575 wt.% of high purity colloidal silica, and 0.0001 wt.% of biocide, and with pH being adjusted to 7.2.

Working composition 2 contained 3.78 wt.% alanine, 0.004 wt.% ethylenediamine, 0.18915 wt.% of amitrole, 0.00963 wt.% of choline bicarbonate, 0.037575 wt.% of high purity colloidal silica, and 0.0001 wt.% of biocide, and with pH being adjusted to 7.2.

All three slurries used 1.5 wt.% of H₂O₂ as oxidizing agent at point of use, respectively. The CMP polishing slurries had a pH at 7.2.

**Table 2. Cu Removal Rate Comparison in High Cu RR Bulk Slurries**

| Compositions | Cu RR (Å/min.) at 2.0psi DF | Cu RR (Å/min.) at 3.0psi DF | Cu RR (Å/min.) at 4.0psi DF |
|---|---|---|---|
| 1X Alanine + 1X Amitrole + 1X CBC + 1X Silica | 5364 | 7672 | 10312 |
| 1X EDA + 1X Amitrole + 1X CBC + 1X Silica | 2455 | 2535 | 2550 |
| 1X Alanine + 1X EDA + 1X Amitrole + 1X CBC + 1X Silica | 5946 | 8114 | 10768 |

As the results shown in Table 2, Cu CMP polishing compositions afforded relative higher Cu film removal rates at different down forces when using two chelators while comparting the Cu removal rates obtained only using a single chelator.

### Example 3

In example 3, both Cu CMP polishing compositions contained two chelators, glycine and ethylenediamine (EDA) at the same wt.% concentrations of 3.78 wt. % and 0.004 wt.% respectively; 0.00963 wt. % of Choline Bicarbonate; 0.0001 wt. % of Biocide; 0.037575 wt. % of high purity colloidal silica. Amitrole was used in Working Composition 3 but not in Working Composition 4. Both polishing compositions have the pH values at about 7.2.

The effects of amitrole in polishing compositions on Cu removal rates were tested and listed in Table 3.

As the results shown in Table 3, at 2.0psi down force, Cu removal rates were increased from 19044Å/min. with amitrole to 25809Å/min. without amitrole used in the CMP polishing composition.

**Table 3. Effects of Amitrole on Cu Removal Rates**

| Compositions | Cu RR (Å/min.) at 2.0psi DF | Cu RR (Å/min.) at 3.0psi DF |
|---|---|---|
| Working Composition 3 | 19044 | 37851 |
| Working Composition 4 | 25809 | 51892 |

As the results further shown in Table 3, at 3.0psi down force, Cu removal rates were increased from 37581Å/min. with amitrole to 51892Å/min. without amitrole used in the CMP polishing composition.

The results shown in Table 3 clearly indicated that with/or without amitrole can be used to tune the desirable high Cu removal rates.

### Example 4

Base composition contained : two chelators, glycine and ethylenediamine (EDA) at the same wt.% concentrations of 3.78 wt. % and 0.004 wt.% respectively; 0.00963 wt. % of Choline Bicarbonate; 0.0001 wt. % of Biocide; 0.037575 wt. % of high purity colloidal silica, and 0.18915 wt.% of amitrole (without H2O2). Different concentrations of hydrogen peroxide (H₂O₂) were added to the base composition to form different compositions as listed in Table 4. Cu removal rates at 2.0psi down force were measured using the compositions.

The Cu removal rate results at 2.0psi DF were listed in Table 4.
As the results shown in Table 4, the high Cu removal rates were obtained within the tested range of H₂O₂ from 1.0 wt. % to 3.0 wt. %.

Furthermore, the high Cu removal rate was tunable by using difference concentration of H₂O₂. For example, by changing the H₂O₂ to 1.5% at the point of use, higher Cu removal rate at 2.0psi DF was achieved with 37706Å/min.

**Table 4. Effects of H₂O₂ wt.% on Cu Removal Rates with Two Chelators Based Cu Slurry**

| Compositions | Cu RR (Å/min.) at 2.0psi DF |
|---|---|
| Base + 1.0% H₂O₂ | 29247 |
| Base + 1.5% H₂O₂ | 37706 |
| Base + 2.0% H₂O₂ | 35205 |
| Base + 2.5% H₂O₂ | 27047 |
| Base + 3.0% H₂O₂ | 21090 |

### Example 5

In Example 5, the working copper CMP polishing compositions as listed in Table 5 were tuned and modified in order to achieve very high Cu film polishing removal rates.

The Cu polishing compositions and the corresponding Cu removal rates obtained at different applied down forces were listed in Table 5.

**Table 5. Cu Removal Rate Comparison in High Cu RR Bulk Slurries**

| Compositions | Cu RR (Å/min.) at 1.0psi DF | Cu RR (Å/min.) at 2.0psi DF | Cu RR (Å/min.) at 3.0psi DF | Cu RR (Å/min.) at 4.0psi DF |
|---|---|---|---|---|
| 1X Glycine + 1X EDA + 1X Amitrole + 1X CBC + Silica | 17537 | 26464 | 36588 | 45839 |
| 1X Glycine + 1X EDA + 0.5X Amitrole + 1X CBC + Silica | 25301 | 34545 | 43603 | 47270 |
| 2X Glycine + 1X EDA + 1X CBC + Silica | 34564 | 47718 | 63683 | 74055 |

As the results shown in Table 5, the high Cu removal rates were achievable and tunable by changing the concentrations of chelator glycine and corrosion inhibitor amitrole, or by removing amitrole from the polishing compositions.

Further, after removing the amitrole and increasing the first chelator glycine concentration in the polishing compositions, the very high Cu removal rate of 74055Å/min. was achieved at 4.0psi down force.

### Example 6

In Example 6, a working CMP polishing composition using glycine and ethylenediamine as dual chelators (as shown in Table 6) was used for obtaining Cu: Ta and Cu: TEOS selectivity at 2.0psi DF condition.

The polishing results and Cu:Ta and Cu:TEOS selectivity were all listed in Table 6.

**Table 6: Cu:Ta and Cu: TEOS Selectivity at 2.0psi DF**

| Compositions | Cu RR (Å/min.) at 2.0psi DF | Ta RR (Å/min.) at 2.0psi DF | TEOS RR (Å/min.) at 2.0psi DF | Cu : Ta Selectivity at 2.0psi DF | Cu:TEOS Selectivity at 2.0psi DF |
|---|---|---|---|---|---|
| 1X Glycine + 1X EDA + 1X Amitrole + 1X CBC + Silica | 26464 | 0 | 0 | Very High | Very High |

As the results shown in Table 6, at 2.0psi down force conditions, the removal rates for both Ta and TEOS film were at 0 Å/min.. Therefore, the Cu: Ta and Cu: TEOS selectivity were very high.

While the invention has been described in conjunction with specific embodiments thereof, it is evident that many alternatives, modifications, and variations will be apparent to those skilled in the art in light of the foregoing description. Accordingly, departures may be made from such details without departing from the spirit or scope of the general inventive concept.

## Claims

1. A copper chemical mechanical polishing (CMP) composition comprising:
a) abrasive;
b) at least two chelators;
c) oxidizing agent; and
d) water;
wherein
the at least two chelators comprise (1) at least one organic amine; and (2) one selected from the group consisting of at least one amino acid, at least one amino acid derivative, and combinations thereof;
and
the pH of the composition is from 5.5 to 7.5.

2. The copper chemical mechanical polishing composition of Claim 1, further comprising
e) corrosion inhibitor;
f) organic quaternary ammonium salt;
g) biocide;
h) pH adjusting agent;
wherein the organic quaternary ammonium salt is selected from the group consisting of choline salt, salt formed between choline and other anionic counter ions, and combinations thereof.

3. The copper chemical mechanical polishing composition of Claim 1 or Claim 2, wherein the organic amine has a general molecular structure selected from the group consisting of: 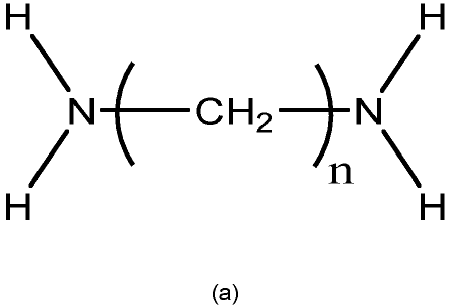
wherein n is from 2 to 12; 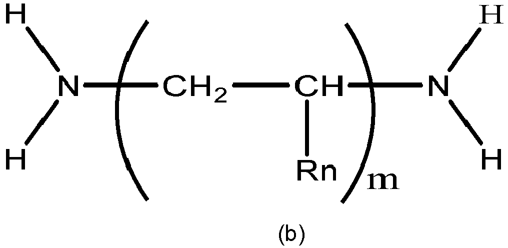
wherein Rn represents an organic alkyl group CₙH₂ₙ₊₁, n is 1 to 12; and m is from 2 to 12; 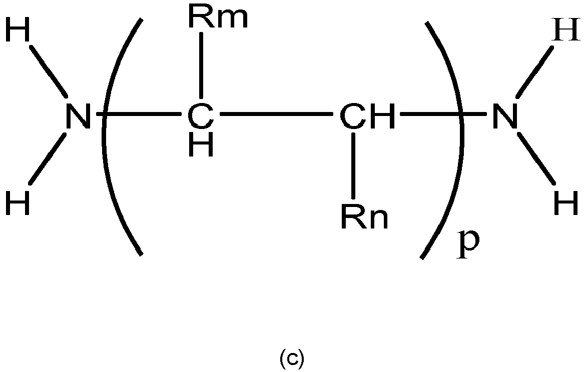 ;
wherein Rn and Rm can be the same or different alkyl groups Rn = CₙH₂ₙ₊₁ and Rm = CₘH₂ₘ₊₁, n is 1 to 12,m is 1 to 12; and p is from 2 to 12; 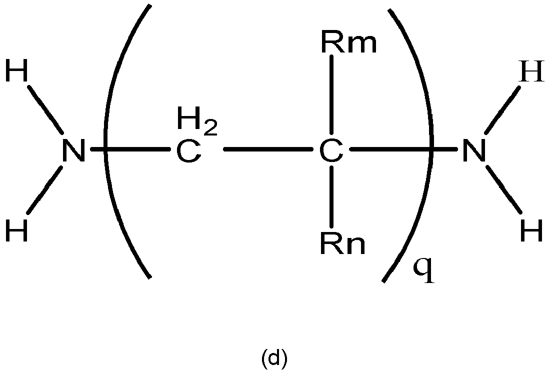
wherein Rn and Rm can be the same or different alkyl groups Rn = CₙH₂ₙ₊₁ and Rm = CₘH₂ₘ₊₁, n is 1 to 12; m is 1 to 12and q is from 2 to 12; 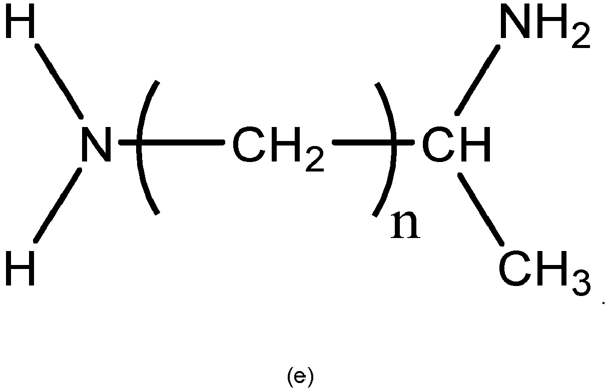
wherein n is from 1 to 12; 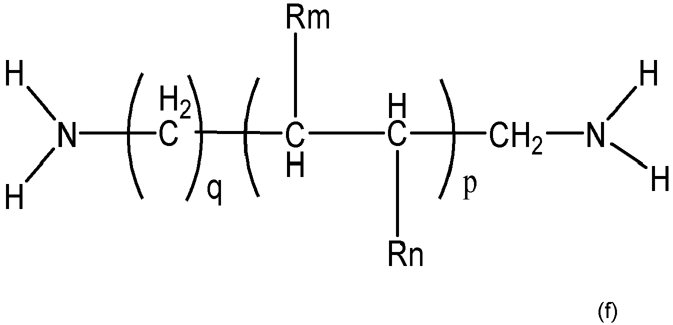
wherein Rn and Rm can be the same or different alkyl groups Rn = CₙH₂ₙ₊₁ and Rm = CₘH₂ₘ₊₁, n is 1 to 12; m is 1 to 12; p is 1 to 12, ; and q is 1 to 6,; 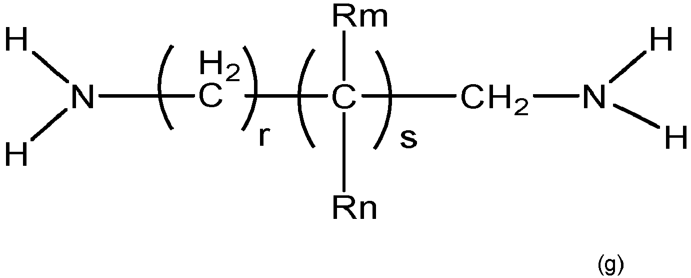
wherein Rn and Rm can be the same or different;Rn is H or CₙH₂ₙ₊₁ and Rm = CₘH₂ₘ₊₁, n is 1 to 12,m is 1 to 12; s is 1 to 12, ; and r is 1 to 6; 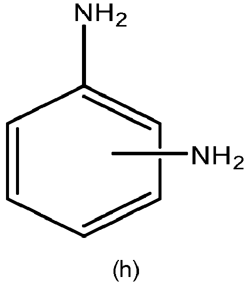 and 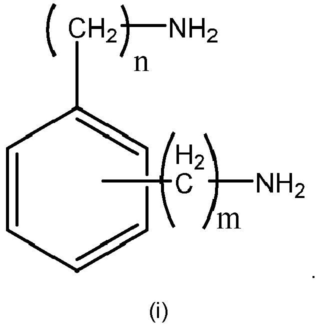
wherein n and m are numbered independently from 1 to 12 ;
and combinations thereof.

4. The copper chemical mechanical polishing composition of any one of claims 2 to 4, wherein
the choline salt has a general molecular structure shown below: 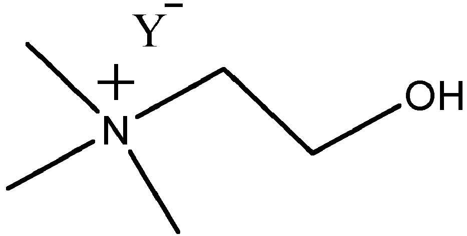 wherein anion Y⁻ can be bicarbonate, hydroxide, p-toluene-sulfonate, or bitartate; the corrosion inhibitor is selected from the group consisting of 1,2,4-triazole, benzotriazole and benzotriazole derivatives, imidazole and imidazole derivatives, benzimidazole and benzimidazole derivatives, pyrazole and pyrazole derivatives, tetrazole and tetrazole derivatives, and combinations thereof.

5. The copper chemical mechanical polishing composition of any preceding claim, wherein the oxidizing agent is selected from the group consisting of periodic acid, hydrogen peroxide, potassium iodate, potassium permanganate, ammonium persulfate, ammonium molybdate, ferric nitrate, nitric acid, potassium nitrate, and combinations thereof.

6. The copper chemical mechanical polishing composition of any preceding claim, wherein the biocide has an active ingredient selected from the group consisting of 5-chloro-2-methyl-4-isothiazolin-3-one, 2-methyl-4-isothiazolin-3-one, and combinations thereof.

7. The copper chemical mechanical polishing composition of any preceding claim, wherein the pH adjusting agent is either (1) selected from the group consisting of nitric acid, hydrochloric acid, sulfuric acid, phosphoric acid, and combinations thereof for adjusting pH toward acidic; or (2) selected from the group consisting of sodium hydroxide, potassium hydroxide, ammonium hydroxide, tetraalkyl ammonium hydroxide, organic amine, and combinations thereof for adjusting pH toward alkaline.

8. The copper chemical mechanical polishing (CMP) composition of any preceding claim,
wherein
the organic amine is selected from the group consisting of ethylenediamine, 1,3-propanediamine, 1,4-butanediamine, 2-methyl-propanediamine, 2-methyl-butanediamine, 2,2-dimethyl-1,3-propanediamine, 2,3-dimethyl-2,3-butanediamine, 2,2-dimethyl-propanediamine and 2,2-dimethyl-butanediamine, 2,3-dimethyl-butane-1,4-diamine, and 2,3-dimethyl-pentane-1,5-diamine, and 2,2-dimethyl-1,4-butanediamine, and the combinations thereof; and/or
the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;

9. The copper chemical mechanical polishing composition of any preceding claim, comprising
0.0025 wt.% to 2.5 wt.% of colloidal silica or high purity colloidal silica;
0.001 to 18.0 total wt. % of (1) at least one of the organic amine selected from the group consisting of ethylenediamine, propylenediamine, and butylenediamine; and (2) at least one of amino acid selected from the group consisting of glycine, D-alanine, L-alanine, DL-alanine, beta-alanine, valine, leucine, isoleucine, phenylamine, proline, serine, threonine, tyrosine, glutamine, asparagine, glutamic acid, aspartic acid, tryptophan, histidine, arginine, lysine, methionine, cysteine, iminodiacetic acid, and combinations thereof;
0.001 wt. % to 0.05 wt. % of choline bicarbonate salt; and
the composition has a pH from 5.5 to 7.5.

10. The copper chemical mechanical polishing composition of any preceding claim, comprises
0.0025 wt.% to 2.5 wt.% of colloidal silica or high purity colloidal silica;
0.5 to 10.0 total wt. % of (1) at least one organic amine selected from ethylenediamine propylenediamine, and butylenediamine; and (2) at least amino acid selected from the group consisting of glycine, D-alanine, L-alanine, DL-alanine, beta-alanine, and combination thereof;
0.001 wt. % to 0.05 wt. % of choline bicarbonate salt; and
the composition has a pH from 5.5 to 7.5.

11. The copper chemical mechanical polishing composition of one of claims 1 to 8, comprising
0.0005 wt.% to 0.15 wt.% of colloidal silica or high purity colloidal silica;
0.5 to 10.0 total wt. % of ethylenediamine; glycine or alanine;
0.002 wt. % to 0.01 wt. % of choline bicarbonate salt;
0.5 wt. % to 3.0 wt. % of periodic acid or hydrogen peroxide;
0.001 wt. % to 0.5 wt. % of 3-amino-1,2,4-triazole, 1,2,4-triazole, or benzotriazole and benzotriazole derivatives;
0.0001 wt.% to 0.025 wt.% of the biocide having an active ingredient selected from the group consisting of 5-chloro-2-methyl-4-isothiazolin-3-one, 2-methyl-4-isothiazolin-3-one, and combinations thereof; and
the composition has a pH from 7.0 to 7.35.

12. A method of chemical mechanical polishing a semiconductor substrate having at least one surface comprising copper (Cu) or copper-containing material and at least one second material; comprising steps of:
1) providing the semiconductor substrate;
2) providing a polish pad;
3) providing a Cu chemical mechanical polishing composition of any one of claims 1 to 11
4) contacting the at least one surface with the polish pad and the Cu chemical mechanical polishing composition; and
5) polishing the at least one surface to remove copper or copper-containing material.

13. The method for chemical mechanical polishing of Claim 12, wherein the second material is selected from the group consisting of barrier layer selected from the group consisting of Ta, TaN, Ti, and TiN film; dielectric layer selected from the group consisting of TEOS, low-k; and ultra low-k film; and removal rate of Cu vs removal rate of the second material is equal or greater than 500:1.

14. A system for chemical mechanical polishing a semiconductor substrate having at least one surface comprising copper (Cu) or copper-containing material and at least one second material; comprising steps of:
1) providing the semiconductor substrate;
2) providing a polish pad;
3) providing a Cu chemical mechanical polishing composition of any one of claims 1 to 11
wherein at least a portion of the at least one surface comprising copper (Cu) or copper-containing material and at least one second material is in contact with both the polishing pad and the Cu chemical mechanical polishing composition.

15. The system of claim 14, wherein the second material is selected from the group consisting of barrier layer selected from the group consisting of Ta, TaN, Ti, and TiN film; dielectric layer selected from the group consisting of TEOS, low-k; and ultra low-k film; and removal rate of Cu vs removal rate of the second material is equal or greater than 500:1.
